# EUROPÄISCHE PATENTSCHRIFT

(11) **EP 3 484 655 B1**
(45) Veröffentlichungstag und Bekanntmachung des Hinweises auf die Patenterteilung: **28.04.2021**
(21) Anmeldenummer: 17752008.7
(22) Anmeldetag: 13.07.2017
(51) Int. Cl.: B23K 26/00, B23K 26/53, B23K 26/03, B23K 101/40, B23K 103/00, H01L 21/78, H01L 21/66

(54) **LASERKONDITIONIERUNG VON FESTKÖRPERN MIT VORWISSEN AUS VORHERIGEN BEARBEITUNGSSCHRITTEN**
LASER CONDITIONING OF SOLID BODIES USING PRIOR KNOWLEDGE FROM PREVIOUS MACHINING STEPS
CONDITIONNEMENT LASER DE SOLIDES BASÉ SUR DES CONNAISSANCES PRÉALABLES PROVENANT D'ÉTAPES DE TRAITEMENT PRÉCÉDENTES

(30) Priorität: 13.07.2016 DE 102016008509
(43) Veröffentlichungstag der Anmeldung: 22.05.2019
(73) Patentinhaber: Siltectra GmbH, 01099 Dresden (DE)
(72) Erfinder: SWOBODA, Marko, 01097 Dresden (DE); RIESKE, Ralf, 01099 Dresden (DE); RICHTER, Jan, 01277 Dresden (DE); SCHILLING, Franz, 01454 Radeberg (DE)
(74) Vertreter: Westphal, Mussgnug Patentanwälte & Partner mbB
(86) Internationale Anmeldenummer: PCT/EP2017/067737
(87) Internationale Veröffentlichungsnummer: WO 2018/011359

(56) Entgegenhaltungen:
- WO-A2-2016/083609
- DE-A1-102014 018 841

## Beschreibung

Die vorliegende Erfindung bezieht sich gemäß Anspruch 1 auf ein Verfahren zum Erzeugung von Steuerdaten zur Nachbearbeitung eines mittels Laserstrahlen modifizierten Festkörpers, gemäß Anspruch 9 auf ein Verfahren zum Erzeugen von Modifikationen in einem Festkörper und gemäß Anspruch 13 auf ein Verfahren zum Abtrennen einer Festkörperscheibe von einem Festkörper.

Im Stand der Technik werden Verfahren beschrieben, wie zum Beispiel in DE102014018841, welche die Erzeugung von Modifikationen in einem Festkörper zur Zerteilung des Festkörpers offenbaren. Die mittels dieser Verfahren abgetrennten Festkörperteile weisen jedoch aufgrund verschiedener verwendeter Materialien und der jeweiligen individuellen Defekte der einzelnen Festkörper oft eine große Dickenschwankung auf. Eine solche Dickenschwankung ist jedoch nachteilig, da nach dem Abtrennen der Festkörperanteile aufwendige Nachbearbeitungen durchgeführt werden müssen.

Es ist somit die Aufgabe der vorliegenden Erfindung ein Verfahren zum Erzeugung von Steuerdaten zur Nachbearbeitung eines mittels Laserstrahlen modifizierten Festkörpers, ein Verfahren zum Erzeugen von Modifikationen in einem Festkörper und ein Verfahren zum Abtrennen einer Festkörperscheibe von einem Festkörper bereitzustellen, wobei Festkörperschichten erzeugt werden sollen, deren Dickenschwankung geringer ist als bei den aus dem Stand der Technik bekannten Verfahren.

Die zuvor genannte Aufgabe wird gemäß Anspruch 1 durch ein Verfahren zum Erzeugung von Steuerdaten zur Nachbearbeitung eines bevorzugt mittels Laserstrahlen modifizierten Festkörpers, insbesondere Wafers, gelöst, wobei der Festkörper in seinem Inneren eine Vielzahl an Modifikationen aufweist, wobei die Modifikationen bevorzugt mittels der Laserstrahlen erzeugt wurden. Dieses Verfahren umfasst bevorzugt mindesten die Schritte: Definieren eines Analysekriteriums zur Analyse der erzeugten Modifikationen im Inneren des Festkörpers; Definieren eines Schwellenwerts hinsichtlich des Analysekriteriums, wobei ein Analysewert einerseits des Schwellenwerts eine Nachbearbeitungsregistrierung auslöst; Analysieren des Wafers mit einer Analyseeinrichtung, wobei die Analyseeinrichtung die Modifikationen hinsichtlich des Analysekriteriums analysiert und Ausgeben von Analysewerten zu den analysierten Modifikationen , wobei die Analysewerte oberhalb oder unterhalb des Schwellwerts liegen; Ausgeben von Ortsdaten zu den analysierten Modifikationen, wobei die Ortsdaten die Informationen enthalten, in welchen/welchem Bereich/en des Festkörpers der Analysewert oberhalb oder unterhalb des Schwellenwerts liegt; Erzeugen der Steuerdaten zum Ansteuern einer Laserbehandlungseinrichtung zum Nachbehandeln des Festkörpers, wobei sie Steuerdaten zumindest die Ortsdaten von den zur Nachbearbeitung registrierten Modifikationen bzw. Festkörperanteile umfassen. Diese Lösung ist vorteilhaft, da im Gegensatz zu vorcharakterisierten Materialinhomogenitäten die vorliegende Erfindung eine optische Charakterisierung während (also zeitgleich) mit der Bearbeitung oder im Anschluss an diese Bearbeitung darstellt. Als Bearbeitung kann im Folgenden die erstmalige Erzeugung von Modifikationen und/oder die Erzeugung von Modifikationen im Rahmen einer Nachbearbeitung bezeichnet werden. Es werden somit erfindungsgemäß Inhomogenitäten in der Materialbearbeitung nachcharakterisiert um eine Folgestrategie für die weitere Bearbeitung zu entwickeln. Es handelt sich also um ein iteratives Bearbeitungsverfahren. Bevorzugt erfolgt die Erzeugung der ersten Modifikationen mit einem ersten Parametersatz, wobei dieser erste Parametersatz z.B. bei der Erzeugung von Modifikationen in einem gleichen Festkörper verwendet wurde, und einer daran anschließenden Weiterentwicklung der Bearbeitung. Die Auswahl der Parameter folgender Iterationen kann bevorzugt über einen Algorithmus oder über eine Reihe von Algorithmen erfolgen und/oder manuell vorgegeben werden. Besonders bevorzugt sind erfindungsgemäß mehrere solcher Iterationen, auch mit unterschiedlichen Strahlungs- oder Rissauslösequellen, wie z.B. Ultraschall, Hitze, Kälteschock, oder mechanisch denkbar. Die Charakterisierung erfolgt bevorzugt durch die Erfassung und Auswertung der auftretenden Reflexion und/oder Transmission von Licht, insbesondere von IR-Strahlung und/oder von sichtbarem Licht. Besonders bevorzugt weist das von der Analyseeinrichtung, insbesondere einer Quelleneinrichtung, emittierte Licht bzw. die Strahlung daher eine Wellenlänge im Bereich zwischen 400nm und 900nm auf. Zusätzlich oder alternativ sind aber auch andere Charakterisierungen mit hoher örtlicher Auflösung denkbar, insbesondere polarisationsabhängige Abbildung, Ultraschall, Röntgen, etc. Die Quellenreinrichtung kann hierbei mindestens oder genau eine Halogenlampe und/oder eine oder mehrere LEDs, insbesondere blitzbare LEDs, aufweisen.

Weitere bevorzugte Ausführungsformen der vorliegenden Erfindung sind Gegenstand der Unteransprüche und/oder der nachfolgenden Beschreibungsteile.

Gemäß einer weiteren bevorzugten Ausführungsform der vorliegenden Erfindung weist die Analyseeinrichtung eine Quelleneinrichtung und eine Detektoreinrichtung bzw. Detektionseinrichtung auf, wobei die Quelleneinrichtung Wellen, insbesondere Lichtwellen, aussendet und die Detektoreinrichtung die durch den Festkörper transmittierten Wellen und/oder die von dem Festkörper reflektierten Wellen erfasst. Bevorzugt erfolgt durch eine Prozessoreinrichtung unmittelbar nach der Detektion oder bereits während der Detektion eine Auswertung der detektierten Parameter, insbesondere des Glanzes.

Die Quelleneinrichtung emittiert gemäß einer weiteren bevorzugten Ausführungsform der vorliegenden Erfindung weißes Licht und die Detektionseinrichtung ist bevorzugt zum Erfassen von Licht unterschiedlicher Farbe ausgebildet, wobei die Detektionseinrichtung ein Mittel zur Detektion von blauem Licht und/oder ein Mittel zur Detektion von rotem Licht und/oder ein Mittel zur Detektion von grünem Licht aufweist. Zusätzlich oder alternativ kann die Detektionseinrichtung zur Detektion von Helligkeit ausgebildet sein. Diese Ausführungsform ist vorteilhaft, da je nach Festkörpermaterial unterschiedliche Lichtbestandteile unterschiedlich reflektiert, absorbiert und transmittiert werden. Die Beurteilung der erfassten Lichtanteile erfolgt bevorzugt in Abhängigkeit von vorgegeben Parametern.

Der Schwellenwert gibt gemäß einer weiteren bevorzugten Ausführungsform der vorliegenden Erfindung vor, wie viele Lichtanteile des mittels einer definierten Lichtquelle emittierten Lichts in einem definierten Festkörperanteil des Festkörpers reflektiert werden müssen, damit für diesen definierten Festkörperanteil kein Nachbearbeitungsbedarf bestimmt wird. Der Schwellenwert gibt ferner bevorzugt an, welche Verteilung an schwarzen oder weißen Pixeln eines sich aus einem Histogramm hinsichtlich blauer Pixel und/oder einem Histogramm hinsichtlich grüner Pixel und/oder einem Histogramm hinsichtlich roter Pixel zusammen gesetzten schwarz/weiß Histogramm für einen definierten Bereich des Festkörpers ergibt. Die Oberflächenbereiche können hierbei gleichförmig gestaltet sein oder unterschiedliche Formen aufweisen. Ferner können die Schwellwerte für unterschiedliche Bereich bzw. für unterschiedliche Oberflächenbereiche unterschiedliche definiert bzw. vorgegeben sein. So kann ein Schwellwert z.B. für Oberflächenbereiche im Randbereich des Festkörpers oder an den Randbereich des Festkörpers anschließend von Oberflächenbereichen im Zentrumsbereichs des Festkörpers verschieden sein.

Der Festkörper wird gemäß einer weiteren bevorzugten Ausführungsform zumindest hinsichtlich der bevorzugt optischen Analyse von Parametern in eine Vielzahl bevorzugt gleichförmige Bereiche unterteilt und für jeden der Bereiche wird bevorzugt eine Analyse hinsichtlich des Analysekriteriums durchgeführt, wobei Steuerdaten zum Nachbehandeln jedes Bereichs erzeugt werden, bezüglich dem die Auswertung der Analysewerte einen Nachbearbeitungsbedarf identifiziert. Diese Ausführungsform ist vorteilhaft, da die Nachbearbeitung eines Bereichs erst dann ausgelöst wird, wenn nicht nur vereinzelte, marginale Mängel detektiert werden, sondern wenn eine Mindestrelevanz (der Schwellenwert) erreicht oder überschritten wurde. Dies ermöglich somit die schnellere Bearbeitung des Festkörpers bei einer gleichzeitigen Sicherstellung des späteren Rissverlaufs.

Die bevorzugt gleichförmigen Bereiche bilden gemäß einer weiteren bevorzugten Ausführungsform der vorliegenden Erfindung eine rechteckige Grundform aus. Bevorzugt werden zusätzlich bzgl. jedem Bereich, für den ein Nachbearbeitungsbedarf identifiziert wird, Steuerdaten zur vollständigen Nachbearbeitung dieses Bereichs erzeugt. Die Steuerdaten sind dann Teil eines Parametersatzes oder bilden den Parametersatz, der zum Ansteuern einer Nachbearbeitung verwendet werden kann.

Besonders bevorzugt wird zusätzlich ein übergeordnetes Schwellwertkriterium angewendet, wobei gemäß dem übergeordneten Schwellwertkriterium die Bereiche, für die ein Nachbearbeitungsbedarf identifiziert wurde, nicht nachbearbeitet werden, wenn die Gesamtfläche dieser Bereiche kleiner als ein vorgegebener Wert, insbesondere weniger als 20% oder weniger als 10% oder weniger als 5% oder weniger als 1%, der Gesamtfläche aller Bereiche, ist und/oder wenn ein Bereich oder mehrere Bereiche sich in einem vorgegebenen Abstand zu dem äußeren Rand des Festkörpers oder zu einem Zentrum des Festkörpers befindet oder befinden.

Bevorzugt wird somit iterativ infolge von Bearbeitungs- und Analyseschritten der Festkörper post- oder in-situ in eine Konfiguration überführt, die eine sehr ebene, homogene Rissführung zulässt bzw. ermöglicht.

Die zuvor genannte Aufgabe wird erfindungsgemäß ebenfalls durch ein Verfahren zum Erzeugen von Modifikationen in einem Festkörper gelöst. Bevorzugt umfasst dieses Verfahren mindestens die Schritte: Erzeugen von Modifikationen mittels Laserstrahlen einer Lasereinrichtung in einem Festkörper, durchführen eines zuvor genannten Verfahrens zum Erzeugung von Steuerdaten zur Nachbearbeitung eines mittels Laserstrahlen modifizierten Festkörpers und erneutes Beaufschlagen der mittels der Steuerdaten identifizierten Bereiche mit Laserstrahlen der Lasereinrichtung. Diese Lösung ist vorteilhaft da die im Rahmen der Nachbearbeitung erzeugten Modifikationen an vorbestimmten Orten und somit zumindest mittelbar in Abhängigkeit einer Information über eine spätere Rissform (ohne Nachbearbeitung) erzeugt werden. Durch die Information über den prognostizierten Rissverlauf, kann bzgl. der Stellen, an denen der Rissverlauf prognostiziert eine Form aufweist, die außerhalb eines Toleranzbereichs liegt, noch vor der Rissführung eine Nachbearbeitung durchgeführt werden, um den Rissverlauf auch bzgl. dieser Stellen innerhalb des Toleranzbereichs zu bringen.

Das Verfahren zum Erzeugung von Steuerdaten zur Nachbearbeitung des mittels Laserstrahlen modifizierten Festkörpers wird gemäß einer weiteren bevorzugten Ausführungsform der vorliegenden Erfindung zumindest zeitweise während der Erzeugung der Modifikationen durchgeführt. Dies ist vorteilhaft, da der Festkörper in einem Arbeitsschritt in die gewünschte Konfiguration überführt wird, wodurch das Verfahren beschleunigt wird.

Gemäß einer weiteren bevorzugten Ausführungsform der vorliegenden Erfindung erfolgt mittels Algorithmen in Abhängigkeit von den erzeugten Modifikationen und/oder von den noch zu erzeugenden Modifikationen nach der Detektion von mindestens einem nachzubearbeitenden Bereich eine Überprüfung in Abhängigkeit eines weiteren Kriteriums, insbesondere Weg- und/oder Zeitkriteriums, wobei in Anhängigkeit von dem weiteren Kriterium weitere Modifikationen erzeugt werden oder die Nachbearbeitung ausgeführt wird. Diese Ausführungsform ist vorteilhaft, da z.B. eine Optimierung des bei der Nachbearbeitung zurückgelegten Weges der Lasereinrichtung gegenüber dem Festkörper (oder vice versa) und/oder der Laserstrahlen vorgenommen wird, wodurch eine Beschleunigung des Verfahrens bewirkt wird.

Die Analyseeinrichtung gemäß einer weiteren bevorzugten Ausführungsform der vorliegenden Erfindung mindestens einen an der Oberfläche des Festkörpers bestimmbaren Parameter analysiert, wobei der Parameter in Abhängigkeit von im Inneren des Festkörpers erzeugten Modifikationen steht und wobei der Parameter bevorzugt der Glanz des Festkörpers ist. Diese Ausführungsform ist vorteilhaft, da bevorzugt rein optisch eine Prognose über den späteren Rissverlauf erzeugbar ist, wodurch noch vor der Rissführung entsprechende Nacharbeiten zum Verbessern der Rissführung durchgeführt werden können.

Die Modifikationen sind gemäß einer weiteren bevorzugten Ausführungsform der vorliegenden Erfindung lokale Risse im Kristallgitter und/oder in mindestens eine andere Phase überführte Materialanteile und/oder die Modifikationen werden mittels über eine äußere Oberfläche des Spendersubstrats bzw. Festkörpers, insbesondere an der das Trägersubstrat angeordnet wird, eingeleitete Laserstrahlen einer als Lasereinrichtung ausgebildeten Strahlungsquelle erzeugt.

Die zuvor genannte Aufgabe wird erfindungsgemäß ebenfalls durch ein Verfahren zum Abtrennen einer Festkörperscheibe bzw. Festkörperschicht bzw. Festkörperlage bzw. eines Wafers von einem Festkörper gelöst. Erfindungsgemäß umfasst dieses Verfahren mindestens die Schritte: Ausführen eines Verfahrens gemäß den Ansprüchen 9 bis 13, Anordnen oder Erzeugen einer Spannungserzeugungsschicht an dem Trägersubstrat; Thermisches Beaufschlagen der Spannungserzeugungsschicht zum Erzeugen von Spannungen in dem Spendersubstrat, wobei durch die Spannungserzeugung ein Riss ausgelöst wird, der sich entlang des vorgegebenen Rissverlaufs zum Abtrennen der Festkörperschicht vom Spendersubstrat ausbreitet, so dass sich die Festkörperschicht mit dem angebondeten Trägersubstrat abtrennt.

Diese Lösung ist vorteilhaft, da durch die vorteilhaft erzeugten Modifikationen in Kombination mit der mittels der Spannungserzeugungsschicht erzeugten Rissauslösung sehr ebene Festkörperscheiben erzeugt werden können.

Die Spannungserzeugungsschicht weist bevorzugt ein Polymer, insbesondere Polydimethylsiloxan (PDMS), auf oder besteht daraus, wobei die thermische Beaufschlagung bevorzugt derart erfolgt, dass das Polymer einen Glasübergang erfährt, wobei die Spannungserzeugungsschicht, insbesondere mittels flüssigem Stickstoff, auf eine Temperatur unterhalb der Raumtemperatur oder unterhalb von 0°C oder unterhalb von -50°C oder unterhalb von -100°C oder unterhalb von -110°C, insbesondere auf eine Temperatur unterhalb der Glasübergangstemperatur der Spannungserzeugungsschicht, temperiert wird. Der Festkörper weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AlN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist bzw. aufweisen oder teilweise aus einem transparenten Material, wie z.B. Korund, insbesondere in der alpha-Phase oder gamma-Phase, besteht oder gefertigt ist bzw. bestehen oder gefertigt sind. Weitere Materialien, die hierbei als Festkörper alleine oder in Kombination mit einem anderen Material in Frage kommen, sind z.B. "wide band gap"-Materialien, InAISb, Hochtemperatursupraleiter, insbesondere seltene Erden Cuprate (z.B. YBa2Cu3O7). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1 %-10%, insbesondere von 1%-5%, insbesondere von 1%-2%, von der Festlegung, die ohne die Verwendung dieser Wörter gegeben wäre. Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts. Weitere Vorteile, Ziele und Eigenschaften vorliegender Erfindung werden anhand nachfolgender Beschreibung anliegender Zeichnungen erläutert, in welchen beispielhaft erfindungsgemäße Vorrichtungen dargestellt sind. Elemente der erfindungsgemäßen Vorrichtungen und Verfahren, welche in den Figuren wenigsten im Wesentlichen hinsichtlich ihrer Funktion übereinstimmen, können hierbei mit gleichen Bezugszeichen gekennzeichnet sein, wobei diese Bauteile bzw. Elemente nicht in allen Figuren beziffert oder erläutert sein müssen. Nachfolgend wird die Erfindung rein beispielhaft anhand der beigefügten Figuren beschrieben.

Darin zeigt:
- Fig. 1a: eine Analysedarstellung eines mit Modifikationen versehenen Festkörpers;
- Fig. 1b: eine Analysedarstellung eines alternativen mit Modifikationen versehenen Festkörpers;
- Fig. 2a: eine Analysedarstellung des in Fig. 1a gezeigten Festkörpers, wobei der Analysebereich in eine Vielzahl an Analyseteilbereiche unterteilt ist;
- Fig. 2b: markierte Analyseteilbereiche, bei denen ein Nachbearbeitungsbedarf ermittelt wurde;
- Fig. 3: die Analysedarstellung des in Fig. 1b gezeigten Festkörpers, wobei Analyseteilbereiche gekennzeichnet sind, für die ein Nachbearbeitungsbedarf ermittelt wurde;
- Fig. 4a: eine weitere Analysedarstellung eines mit Modifikationen versehenen Festkörpers;
- Fig. 4b: die untere Hälfte des in Fig. 4a gezeigten Festkörpers nach einer Teilung des Festkörpers entlang einer durch die Modifikationen vorgegebenen Rissausbreitungsebene;
- Fig. 4c: die obere Hälfte des in Fig. 4a gezeigten Festkörpers nach einer Teilung des Festkörpers entlang einer durch die Modifikationen vorgegebenen Rissausbreitungsebene;
- Fig. 5a: schematisch eine Analysedarstellung, insbesondere ein Glanzbild, eines Festkörpers nach der Erzeugung der Modifikationen;
- Fig. 5b: eine weitere schematische Analysedarstellung des in Fig. 5a gezeigten Festkörpers nach einer Nachbearbeitung;
- Fig. 6: schematisch einen Ablaufplan des erfindungsgemäßen Verfahrens zum Abtrennen einer Festkörperscheibe von einem Festkörper;
- Fig. 7a-7d: Histogramme zu einem Analyseteilbereich;
- Fig. 7e: der Analyseteilbereich, zu dem die Histogramme der Figuren 7a-7d erzeugt wurden;
- Fig. 8a-8d: Histogramme zu einem Analyseteilbereich; und
- Fig. 8e: der Analyseteilbereich, zu dem die Histogramme der Figuren 8a-8d erzeugt wurden.

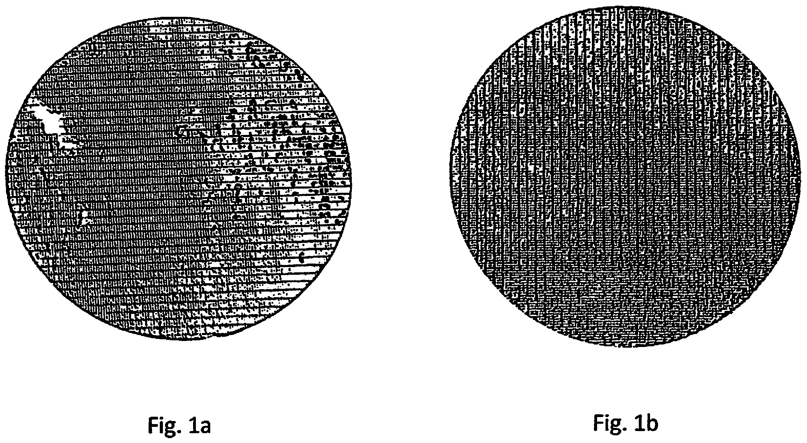

Die Fig. 1a und 1b zeigen jeweils Analysedarstellungen von Festkörpern 1 nach der Erzeugung von Modifikationen 12 innerhalb des jeweiligen Festkörpers 1. Die Modifikationen 12 innerhalb des jeweiligen Festkörpers 1 dienen zum Vorgeben eines Ablösebereichs bzw. eines Rissführungsbereichs, entlang dem ein Teil, insbesondere eine Festkörperschicht, von dem Festkörper abgelöst bzw. abgetrennt werden kann.

Die Analysedarstellung der Fig. 1a zeigt ein deutlich heterogeneres Bild als die Analysedarstellung der Fig. 1b. Eine Analysedarstellung, wie sie in Fig. 1a gezeigt ist, resultiert z.B. aus Einschlüssen oder sonstigen Defekten der Gitterstruktur des Festkörpers 1.

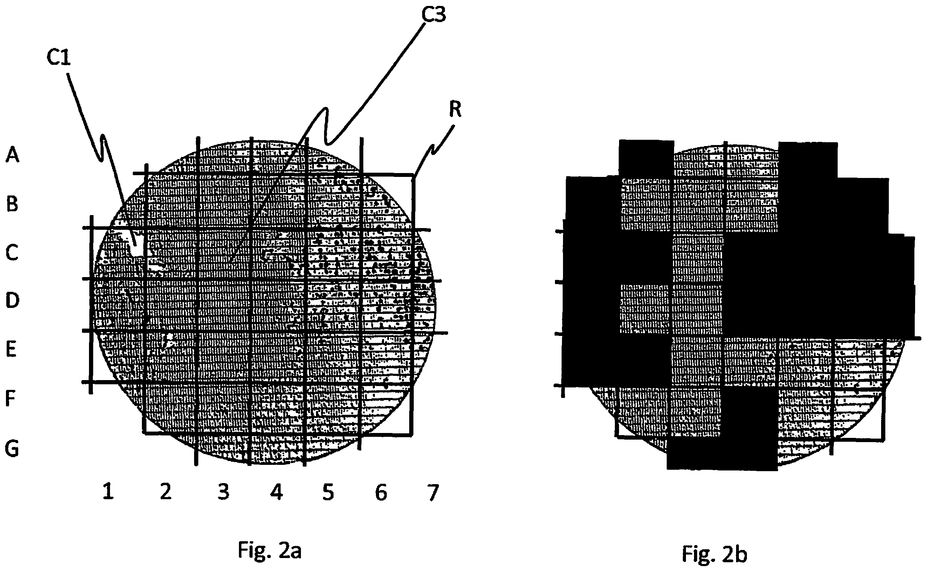

Fig. 2a zeigt eine Unterteilung des Analysebereichs in Analyseteilbereiche. Bevorzugt wird hierbei jeder Analyseteilbereich mittels der Analyseeinrichtung analysiert. Die Analyse eines Analyseteilbereichs erfolgt bevorzugt mittels der Beaufschlagung des Analyseteilbereichs mit Wellen, insbesondere mit Lichtwellen. Mittels einer Detektionseinrichtung 6 erfolgt eine Erfassung bzw. Bestimmung der reflektierten und/oder transmittierten und/oder absorbierten Wellen. Es ist ersichtlich, dass der Analyseteilbereich C3 eine deutlich andere Erscheinung und somit unterschiedliche Eigenschaften, insbesondere unterschiedliche mechanische und/oder chemische Eigenschaft, aufweist als z.B. der Analyseteilbereich C1.

Besteht der Festkörper z.B. aus Siliziumkarbid, so werden die Modifikationen in einem bevorzugten Fall mittels eines Femtosekundenlaser und somit mittels Femtosekundenpulsen erzeugt. Dabei wird bevorzugt eine numerische Apertur von bevorzugt zwischen 0,1 und 1, insbesondere von 0,65 bzw. von im Wesentlichen 0.65, verwendet. Der Festkörper wird dabei bevorzugt in einer Tiefe von 20 bis 500µm, insbesondere in einer Tiefe von 50µm bis 300µm, wie z.B. in einer Tiefe von 180µm oder von im Wesentlichen 180µm, durch das Erzeugen von Modifikationen 12, insbesondere durch das Schreiben von Linien, vorkonditioniert. Die Modifikationen 12 werden bevorzugt in einer solchen Anordnung erzeugt, dass sich bei entsprechender Auflösung Linien ergeben. Die Modifikationen 12 werden somit bevorzugt nach einander in derselben Richtung und besonders bevorzugt mit demselben Abstand zueinander erzeugt. Weiterhin werden bevorzugt mehrere Linien aus Modifikationen 12 nebeneinander erzeugt, insbesondere parallel zueinander. Bevorzugt werden die einzelnen Linien im selben Abstand zueinander oder im Wesentlichen im selben Abstand zueinander erzeug. Weiterhin können weitere Linien aus Modifikationen 12 erzeugt werden, die gegenüber den anderen Linien geneigt, insbesondere orthogonal, ausgerichtet sind. Bevorzugt schneiden die Linien, die sich in einer ersten Richtung erstrecken, eine Vielzahl an Linien, die sich bevorzugt in einer anderen Richtung erstrecken.

Im Inneren des Festkörpers 1 findet besonders bevorzugt eine Phasenumwandlung des Materials des Festkörpers 1 statt. Im Falle von Siliziumkarbid, bewirkt die Phasenumwandlung das Vorliegen von Material in einer Kohlenstoff- und in einer Siliziumphase. Dies führt erfindungsgemäß zu Mikrorissen im Inneren des Festkörpers 1, wobei die Mikrorisse bevorzugt eine Schwärzung des Materials des Festkörpers 1 darstellen. Durch die erzeugten Phasen werden Stresszonen im Material gebildet. Dies ergibt sich aus der Ausdehnung der neuen Phasen im Inneren des Festkörpers 1. So sind z.B. die Kohlenstoff- und die Siliziumphase volumenmäßig größer als der entsprechende SiC-Kristallgitterteil vor der Umwandlung. Dies bewirkt die Erzeugung von Druckspannung im Inneren des Festkörpers 1, wodurch sich Risse entlang der Kristallebenen von Siliziumkarbid auslösen. Die ausgelösten Risse können in einer Analysedarstellung als charakteristischer Glanz des Materials wahrgenommen werden.

Ein Analysekriterium kann somit z.B. der Glanz des Festkörpers 1 sein, da sich dieser in Abhängigkeit von den im Festkörper 1 erzeugten Modifikationen 12, insbesondere von den durch die Modifikationen 12 bewirkten Rissen, bei einer entsprechenden bzw. vordefinierten Beleuchtung ergibt. Das Bezugszeichen C3 kennzeichnet somit einen Analyseteilbereich mit homogener Rissausbreitung und daher mit hohem Glanzanteil. Hingegen kennzeichnet das Bezugszeichen C1 einen Analyseteilbereich mit weniger Glanz und somit mit nicht komplett flächig ausgelösten Rissen im Kristall.

Bevorzugt sind die Felder (C1, C3) eines Rasters R kleiner als 100cm², oder kleiner als 50cm² oder kleiner als 10cm² oder kleiner als 5cm² oder kleiner als 1cm² oder kleiner als 0,5cm² oder kleiner als 0,1 cm².

Fig. 2b zeigt eine gegenüber der Darstellung von Fig. 2a modifizierte Darstellung. Hierbei sind mittels des erfindungsgemäßen Verfahrens zum Erzeugung von Steuerdaten 3 zur Nachbearbeitung eines mittels Laserstrahlen 10 modifizierten Festkörpers 1, insbesondere Wafers, identifizierten Bereiche, für die ein Nachbearbeitungsbedarfs identifiziert wurde, gekennzeichnet dargestellt. Die gekennzeichneten Bereiche sind hierbei durch schwarze Felder gekennzeichnet. Gemäß dem erfindungsgemäßen Verfahren bevorzugt zunächst ein Analysekriterium zur Analyse der im Inneren des Festkörpers 1 erzeugten Modifikationen 12 definiert. Weiterhin erfolgt das Definieren eines Schwellenwerts hinsichtlich des Analysekriteriums, wobei ein Analysewert einerseits des Schwellenwerts eine Nachbearbeitungsregistrierung auslöst. Anschließend wird der Festkörper 1 mit einer Analyseeinrichtung 4 analysiert, wobei die Analyseeinrichtung 4 die Modifikationen 12 hinsichtlich des Analysekriteriums analysiert. Die Analysewerte werden dann in einem weiteren Schritt ausgeben, wobei die Analysewerte zumindest mehrheitlich oberhalb oder unterhalb des Schwellwerts liegen. Ferner werden Ortsdaten ausgegeben, wobei die Ortsdaten die Informationen enthalten, in welchen/welchem Bereich/en des Festkörpers 1 der Analysewert oberhalb oder unterhalb des Schwellenwerts liegt. Weiterhin werden Steuerdaten 3.1 zum Ansteuern einer Laserbehandlungseinrichtung 20 zum Nachbehandeln des Festkörpers 1 erzeugt, wobei sie Steuerdaten 3.1 zumindest die Ortsdaten von den zur Nachbearbeitung registrierten Modifikationen 12 bzw. Festkörperanteilen umfassen. Die Laserbehandlungseinrichtung kann hierbei der Lasereinrichtung 11 entsprechen bzw. diese sein. Die zur Nacharbeitung registrierten Modifikationen 12 bzw. Modifikationsbereiche werden im in Fig. 2b gezeigten Fall schematisch als schwarze Rechtecke dargestellt. Es ist hierbei denkbar, dass die Modifikationsbereiche bzw. Analyseteilbereiche rechteckig, dreieckig, polygon oder teilweise oder vollständig gebogen, insbesondere elliptisch oder rund ausgebildet bzw. vorgesehen sind.

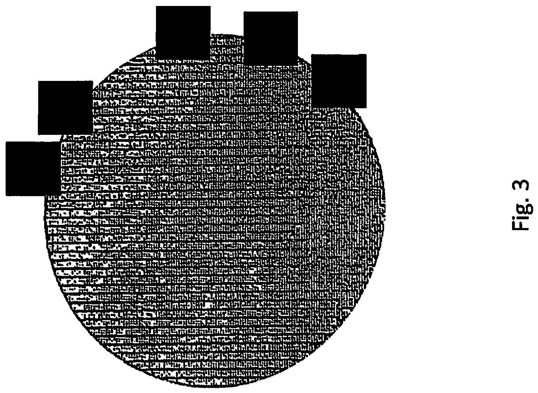

Fig. 3 zeigt die Analysedarstellung des in Fig. 1b gezeigten Festkörpers, wobei Analyseteilbereiche gekennzeichnet sind, für die ein Nachbearbeitungsbedarf ermittelt wurde.

Es ist hierbei ersichtlich, dass das bzgl. Fig. 2b gezeigte Raster nicht stets dieselbe Form aufweisen muss. Weiterhin werden bevorzugt nur die Anteile für die Nachbearbeitung registriert die Bestandteil des Festkörpers sind. Die Anteile der Analyseteilbereiche, die außerhalb des Festkörpers 1 liegen, werden besonders bevorzugt weder analysiert noch im Rahmen einer Nachbearbeitung mit Laserstrahlen beaufschlagt. Bevorzugt sind die Felder eines Rasters kleiner als 100cm², oder kleiner als 50cm² oder kleiner als 10cm² oder kleiner als 5cm² oder kleiner als 1cm² oder kleiner als 0,5cm² oder kleiner als 0,1cm².

Die verbleibenden Anteile (die nicht von schwarzen Rechtecken überdeckt sind) sind sehr homogen, wodurch eine Nachbearbeitung hier nicht erforderlich ist. Ferner ist denkbar, dass auch in den Bereichen, für die ein Nachbearbeitungsbedarf erkannt wurde, keine Nachbearbeitung durchgeführt wird, da der Gesamtnachbearbeitungsbedarf kleiner oder größer als ein vorgestimmtes übergeordnetes Schwellenwertkriterium ist. Gemäß dem übergeordneten Schwellwertkriterium werden die Bereiche, für die ein Nachbearbeitungsbedarf identifiziert wurde, nicht nachbearbeitet, wenn die Gesamtfläche dieser Bereiche kleiner als ein vorgegebener Wert, insbesondere weniger als 20% oder weniger als 15% oder weniger als 10% oder weniger als 5% oder weniger als 3% oder weniger als 1% der Gesamtfläche aller Bereiche, ist und/oder wenn ein Bereich oder mehrere Bereiche sich in einem vorgegebenen Abstand zu dem äußeren Rand des Festkörpers 1 oder zu einem Zentrum des Festkörpers 1 befindet oder befinden.

Erfindungsgemäß können weiterhin Festkörperanteile, für die kein Nachbearbeitungsbedarf ermittelt wurde für eine Nachbehandlung teilweise oder vollständig registriert werden, wenn einer oder mehrere derartiger Festkörperanteile zwischen Festkörperanteilen liegen, für die ein Nachbearbeitungsbedarf identifiziert wurde.

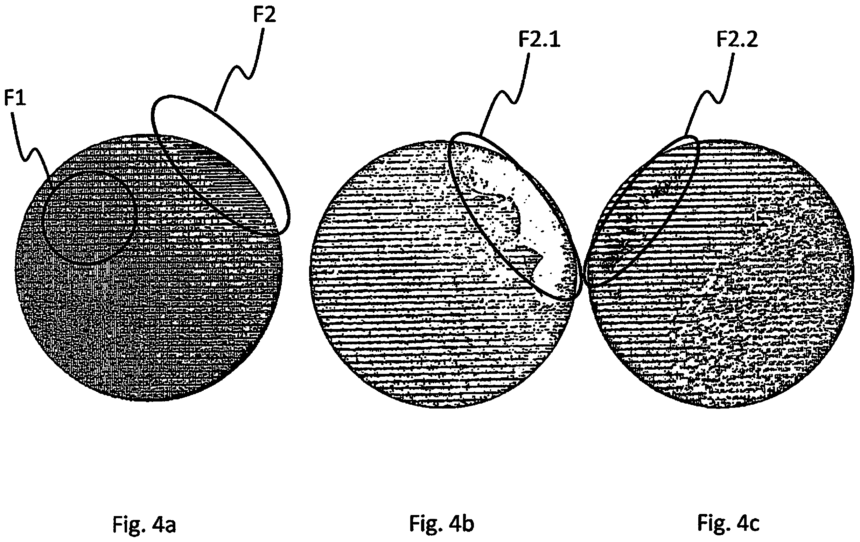

Fig. 4a zeigt eine Analysedarstellung, insbesondere ein Glanzbild, eines mit Modifikationen versehenen Festkörpers 1. Das Feld F1 kennzeichnet einen Bereich mit sehr homogener Rissausbreitung und das Feld F2 kennzeichnet einen Bereich mit sehr heterogener Rissausbreitung.

Fig. 4b zeigt die Oberfläche eines ersten (insbesondere unteren) abgetrennten Festkörperanteils, insbesondere eines Ingots, nach dem Absplitten einer Festkörperschicht 1 (vgl. Fig. 4c). Es ist erkennbar, dass das in Fig. 4a sichtbare Feld F2 ebenfalls in der späteren durch den Splitt freigelegten Oberfläche ein gegenüber den verbleibenden Anteilen sehr heterogen ausgebildetes Feld F2.1 bewirkt. Weiterhin weist die in Fig. 4c gezeigte weitere freigelegte Oberfläche ein Feld F2.2 auf, das korrespondierend, insbesondere negativ, zu dem Feld F2.1 (vgl. Fig. 4b) ausgebildet ist.

Es wurde somit vorliegend erkannt, dass Risse und ihr spezielles optisches Signal gute Indikatoren für den Erfolg einer Laserbearbeitung in der Ebene und die daraus resultierende spätere Abspaltung einer Festkörperschicht 4 von dem Festkörper 1 bzw. einer Teilung des Festkörpers sind.
Regionen ohne ausgelöste Risse (z.B. nachgewiesen durch Glanz = optisches Signal) zeigen somit noch vor der Ablösung bzw. Abtrennung der Festkörperschicht 4 Fehler. Diese Fehler führen bei der Abtrennung einer Festkörperschicht 4 zu unerwünschten Unebenheiten bzw. Dickenschwankungen, die stärker sind als in den anderen Bereichen, die zu Aufbereitungsprozessen oder zu Ausschuss führen. Je größer bei den Aufbereitungsprozessen (z.B. Schleifen) der Materialabtrag ist, desto dicker muss die Festkörperscheibe 4 sein, um den eventuellen Materialabtrag kompensieren zu können. Es ist ersichtlich, dass dies zu hohem Materialverbrauch führt und zudem sehr flexible nachgelagerte Prozesse erfordert. Die Ausräumung solcher Probleme durch das Ausnutzen der nach der Modifikation 12 mittels Wellen erhaltbaren Information über die Rissverteilung im Inneren des Festkörpers 1 ermöglicht somit eine vorteilhafte Nachbearbeitung noch bevor eine Festkörperschicht 4 abgespaltet wurde.

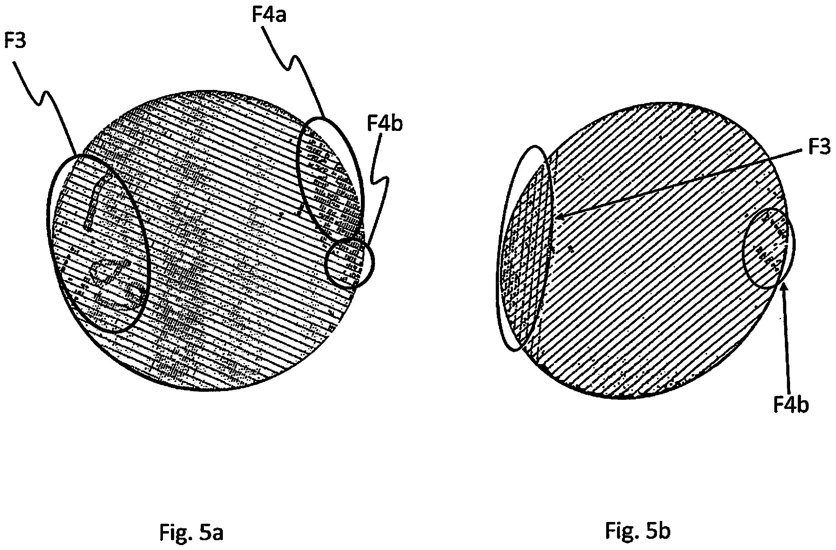

Fig. 5a zeigt eine Analysedarstellung eines Festkörpers 1 nach der Erzeugung der Modifikationen 12 im Inneren des Festkörpers 1. Die Felder F3 und F4a wurden nachbearbeitet. Daraus ergab sich dann die in Fig. 5b dargestellte deutlich homogenere Analysedarstellung. Lediglich der nicht nachbearbeitete Bereich F4b weist eine stärkere Inhomogenität auf. In den nachbearbeiteten Anteilen wurde durch die Nachbearbeitung eine Rissausbreitung im Inneren des Festkörpers 1, insbesondere durch einzelne oder mehrere Modifikationen 12 hindurch oder entlang einzelner oder mehrerer Modifikationen 12, bewirkt. In dem nicht nachbearbeiteten Anteil F4b bestehen somit weiterhin Fehlstellen.

Die Nachbearbeitung verbessert somit einen Parameter, der bevorzugt optisch erfasst werden kann und besonders bevorzugt in Abhängigkeit von der Größe und/oder Anzahl der erzeugten Modifikationen 12 steht, bevorzugt handelt es sich bei diesem Parameter um den bei einer definierten Beleuchtung resultierenden Glanz des Festkörpers 1. Eine Nachbearbeitung verbessert somit die Rissauslösung in Regionen mit vermindertem optischen Signal. Nach der ersten Bearbeitung oder während der ersten Bearbeitung erfolgt somit bevorzugt die Detektion der nachzubearbeitenden Regionen, insbesondere über ein optisches
Signal, wie z.B. den Glanz.

Bevorzugt erfolgt eine in-situ Detektion des zu analysierenden Parameters, insbesondere des optischen Signals. Das optische Signal des Bearbeitungserfolgs repräsentiert hierbei bevorzugt ortsaufgelöst den Rissglanz des Festkörpers 1. Dieser Parameter, insbesondere das optische Signal des Rissglanzes, kann während der Bearbeitung aufgezeichnet werden. Aus den aufgezeichneten Daten kann eine Karte des Materials erstellt werden, die für eine Nachbearbeitung verwendet wird.

Alternativ kann durch eine Detektionseinrichtungslösung, insbesondere mit einer Kamera, die Probe hinsichtlich des Parameters, insbesondere in Reflexion, abgebildet werden und das Signal kann dann bevorzugt auch noch während der Bearbeitung, insbesondere der Erzeugung der Modifikationen 12 und/oder während der Nachbearbeitung, ausgewertet und für einen bevorzugt integralen Nachbearbeitungsschritt verwendet werden.

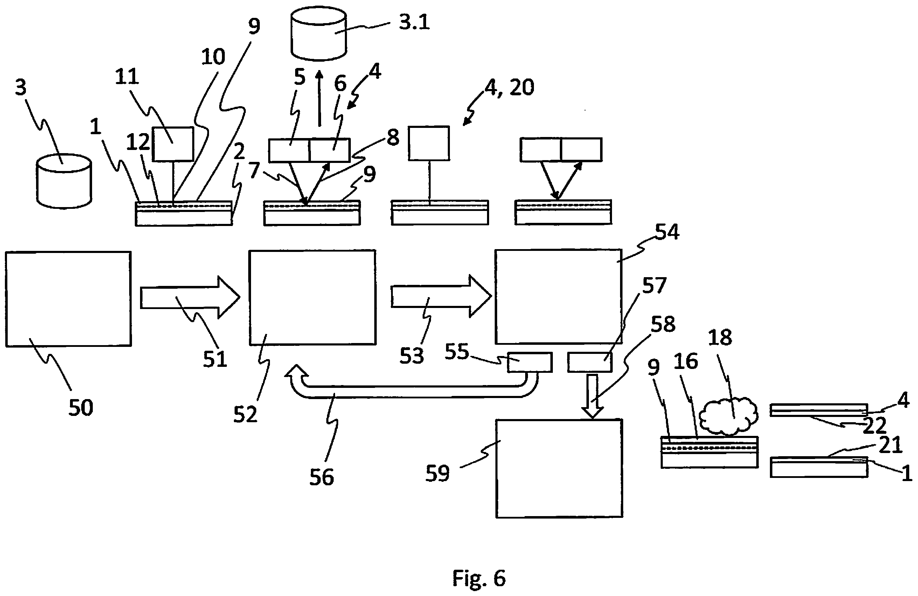

Fig. 6 zeigt ein schematisches Verfahren und jeweils schematisch Beispiele für die in den jeweiligen Verfahrensschritten konkret erfolgenden Abläufe.

Das Bezugszeichen 50 kennzeichnet hierbei bevorzugt den Eingang des Materials, insbesondere des Festkörpers 1, und die Registrierung der für die erste Bearbeitung des Materials bestimmten Parameter bzw. des bestimmten Parametersatzes. Der Parametersatz umfasst dabei bevorzugt Daten zur Ansteuerung einer Analyseeinrichtung 4, insbesondere einer Quellen- und/oder Detektionseinrichtung, wie z.B. die Welleneigenschaften der auszustrahlenden Wellen und/oder Schwellenwerte zur Handhabmachung der mittels der Detektionseinrichtung 6 erfassten Daten. Das Bezugszeichen 3 kennzeichnet hierbei ein Symbol, das im Rahmen der vorliegenden Erfindung die Registrierung des zur Bearbeitung des Materials bereitgestellten Parametersatzes repräsentiert. Die Bearbeitung des Materials bzw. des Festkörpers 1 wird in dem schematischen Verfahren durch den mit dem Bezugszeichen 51 gekennzeichneten Pfeil angezeigt. Bei diesem Schritt erfolgt bevorzugt eine Laserbeaufschlagung eines auf einer Aufnahmeeinrichtung 2, insbesondere einem Chuck, fixierten Festkörpers 1 mit Laserstrahlung 10 einer Lasereinrichtung 11. Die Laserstrahlen 10 dringen dabei über eine Oberfläche 9 des Festkörpers 1, an der eine Spannungserzeugungsschicht 16 angeordnet wird, in den Festkörper 1 ein. Durch die Laserstrahlen 10 werden bevorzugt eine Vielzahl an Modifikationen 12 im Inneren des Festkörpers 1 erzeugt. Die Modifikationen 12 stellen dabei bevorzugt Veränderungen des Kristallgitters des Festkörpers 1 dar. Bevorzugt können die Modifikationen 12 in eine andere Phase überführte Materialanteile des Festkörpers 1 oder Risse im Festkörper 1 oder zerstörte Materialanteile im Inneren des Festkörpers 1 darstellen.

Das Bezugszeichen 52 kennzeichnet einen weiteren Verfahrensschritt, nämlich die post- oder in-situ Detektion bzw. Analyse zur Festlegung eines modifizierten bzw. weiteren Parametersatzes. Bevorzugt weist hierbei die Analyseeinrichtung 4 eine Quelleneinrichtung 5, insbesondere eine IR-Lichtquelle oder eine Lichtquelle, die bevorzugt sichtbares Licht emittiert, zum Emittieren von Licht 7 und eine Detektionseinrichtung 6 zum Erfassen der reflektierten Anteile 9 des Lichts auf. Das Licht 7 bzw. die Strahlung dringt dabei zu einem Mindestanteil in den Festkörper 1 ein und wird dann zumindest anteilig von den erzeugten Modifikationen 12 reflektiert. Bevorzugt bilden die Modifikationen 12 dabei Risse im Kristallgitter des Festkörpers 1 aus und das Licht 7 bzw. die Strahlung wird an den durch die Risse, insbesondere Mikrorissen, entstandenen Kornkanten reflektiert.

Aus den detektierten Daten wird dann bevorzugt ein neuer oder modifizierter Parametersatz 3.1 erzeugt, der bevorzugt zur Ansteuerung einer Nachbearbeitungseinrichtung 20 dient. Es ist hierbei jedoch denkbar, dass die Nachbearbeitungseinrichtung 20 und die Lasereinrichtung 11 identisch bzw. dieselbe Einrichtung sind.

Mittels der Nachbearbeitungseinrichtung 20 wird dann gemäß dem Verfahrensschritt 53 eine Nachbearbeitung des Festkörpers 1 in Abhängigkeit von dem neuen oder modifizierten Parametersatz 3.1 durchgeführt.

Das Bezugszeichen 54 kennzeichnet analog zum Bezugszeichen 52 eine weitere post- oder in-situ Detektion bzw. Analyse. Es wird hierbei bevorzugt überprüft, ob die Nachbearbeitung erfolgreich war. Entspricht das Detektions- oder Analyseergebnis nicht den Vorgaben (Entscheidungsfeld 55), dann wird erneut ein neuer oder modifizierter Parametersatz zur weiteren Nachbearbeitung des Festkörpers 1 erzeugt. Sollte das Detektions- oder Analyseergebnis den Vorgaben entsprechen (Entscheidungsfeld 57), dann wird der Festkörper 1 weiteren Prozessschritten 59, insbesondere einem cold split Prozess, zugeführt. Bevorzugt wird auf den Festkörper 1 eine Spannungserzeugungsschicht 16, insbesondere eine Polymerschicht, aufgebracht. Diese Spannungserzeugungsschicht 16 wird dann bevorzugt derart beaufschlagt, insbesondere mit einem Fluid 18, insbesondere mit einem Gas oder einer Flüssigkeit, mit einer Temperatur unterhalb der Glasübergangstemperatur des Materials der Spannungserzeugungsschicht 16, insbesondere mit einem Fluid 18 mit einer Temperatur von weniger als 15°C oder von weniger als 0°C oder von weniger als -10°C oder von weniger als -50°C oder von weniger als -100°C. Dies bewirk die Erzeugung von mechanischen Spannungen im Inneren des Festkörpers 1, wodurch sie ein Riss entlang eines durch die Modifikationen 12 definierten Ablösebereichs ausbreitet. Daraus ergibt sich eine abgetrennte Festkörperschicht 4, mit einer neuen Oberfläche 22 und ein reduzierter Festkörper 1 mit einer neuen Oberfläche 21.

Dieses Verfahren ist neben Siliziumkarbid bevorzugt ebenfalls für Silizium, Galiumnitrid, Aluminiumnitrid, Galliumarsenid und andere Materialien verwendbar.

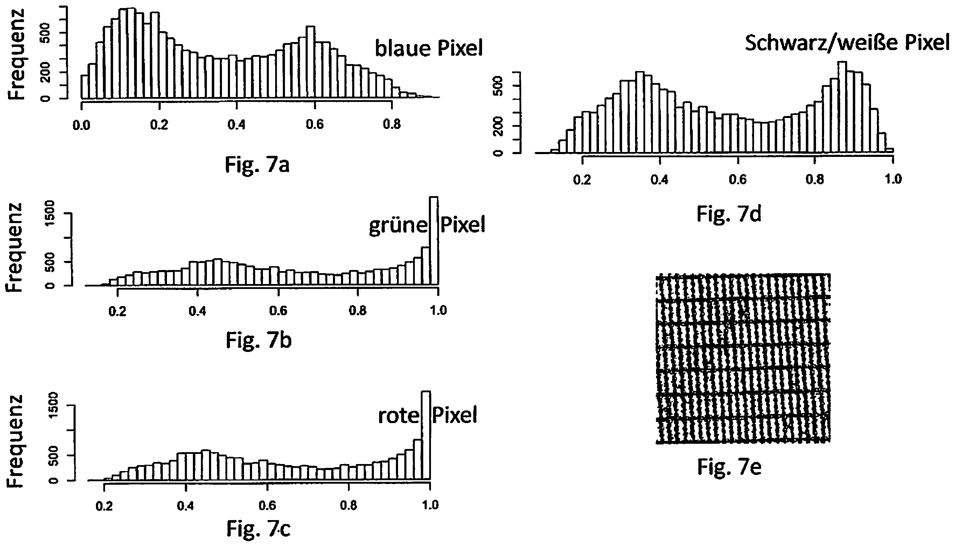

Fig. 7e zeigt eine Aufnahme eines Analyseteilbereichs. Die Figuren 7a bis 7c zeigen Histogramme zu dem in Fig. 7e gezeigten Analyseteilbereich. Fig. 7d zeigt ein Histogramm für schwarz/weiße Pixel bzgl. dem in Fig. 7e gezeigten Analysebereich. Das Histogramm bzgl. schwarz/weiß setzt sich bevorzugt aus den Histogrammen für blaue, rote und grüne Pixel zusammen. Würde z.B. ein Schwellenwert im schwarz/weißen Histogramm festgelegt werden, wie z.B. 0,6, so würden in dem gezeigten speziellen Beispiel die Schwarzanteile z.B. 55,35% und die Weißanteile z.B. 44,65% ausmachen.

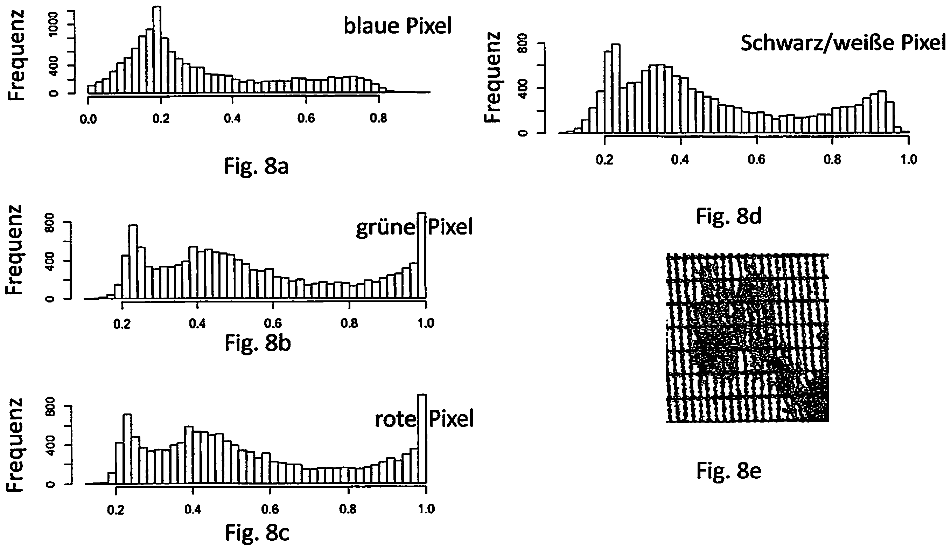

Fig. 8e zeigt eine Aufnahme eines Analyseteilbereichs. Die Figuren 8a bis 8c zeigen Histogramme zu dem in Fig. 8e gezeigten Analyseteilbereich. Fig. 8d zeigt ein Histogramm für schwarz/weiße Pixel bzgl. dem in Fig. 8e gezeigten Analysebereich. Das Histogramm bzgl. schwarz/weiß setzt sich bevorzugt aus den Histogrammen für blaue, rote und grüne Pixel zusammen. Würde z.B. ein Schwellenwert im schwarz/weißen Histogramm festgelegt werden, wie z.B. 0,6, so würden in dem speziellen Beispiel die Schwarzanteile z.B. 71,1% und die Weißanteile z.B. 28,9% ausmachen.

Aus den Darstellungen 7e und 8e lässt sich der im jeweiligen schwarz/weiß Histogramm abgebildete Zusammenhang bzgl. der Schwarzanteile im Bild und der Homogenität des Bildes deutlich erkennen.

Erfindungsgemäß wird somit ein Verfahren zum Erzeugung von Steuerdaten zur Nachbearbeitung eines mittels Laserstrahlen 10 modifizierten Festkörpers 1, insbesondere Wafers, bereitgestellt, wobei der Festkörper 1 in seinem Inneren eine Vielzahl an Modifikationen 12 aufweist, wobei die Modifikationen 12 mittels der Laserstrahlen 10 erzeugt wurden. Bevorzugt umfasst das erfindungsgemäße Verfahren mindestens die Schritte: Definieren eines Analysekriteriums zur Analyse der erzeugten Modifikationen 12 im Inneren des Festkörpers 1; Definieren eines Schwellenwerts hinsichtlich des Analysekriteriums, wobei ein Analysewert einerseits des Schwellenwerts eine Nachbearbeitungsregistrierung auslöst; Analysieren des Wafers mit einer Analyseeinrichtung 4, wobei die Analyseeinrichtung 4 die Modifikationen 12 hinsichtlich des Analysekriteriums analysiert und Ausgeben von Analysewerten, wobei die Analysewerte oberhalb oder unterhalb des Schwellwerts liegen; Ausgeben von Ortsdaten, wobei die Ortsdaten die Informationen enthalten, in welchen/welchem Bereich/en des Festkörpers 1 der Analysewert oberhalb oder unterhalb des Schwellenwerts liegt; Erzeugen der Steuerdaten zum Ansteuern einer Laserbehandlungseinrichtung 11 zum Nachbehandeln des Festkörpers 1, wobei sie Steuerdaten zumindest die Ortsdaten von den zur Nachbearbeitung registrierten Modifikationen 12 umfassen.

### Bezugszeichenliste

- 1: Festkörper
- 2: Spendersubstrat
- 3: Parametersatz
- 3.1: modifizierter bzw. neuer Parametersatz
- 4: Analyseeinrichtung
- 5: Quelleneinrichtung
- 6: Detektionseinrichtung
- 7: Wellen
- 8: Reflektierte Anteile der Wellen 7
- 9: Oberfläche des Festkörpers
- 10: Laserstrahlen
- 11: Lasereinrichtung
- 12: Modifikationen
- 16: Spannungserzeugungsschicht
- 18: Kühlmittel
- 20: freigelegte neue Oberfläche des reduzierten Festkörpers
- 22: freigelegte neue Oberfläche der abgetrennten Festkörperschicht
- 50-59: Schritte im bevorzugten Verfahrensablauf
- F1: Feld F1
- F2: Feld F2
- F2.1: Oberflächenstruktur im Bereich des Feldes F2 einerseits des Splits
- F2.2: Oberflächenstruktur im Bereich des Feldes F2 andererseits des Splits

## Patentansprüche

1. Computerimplementiertes Verfahren zum Erzeugung von Steuerdaten zur Nachbearbeitung eines mittels Laserstrahlen (10) modifizierten Festkörpers (1), wobei der Festkörper (1) in seinem Inneren eine Vielzahl an Modifikationen (12) aufweist, wobei die Modifikationen (12) mittels der Laserstrahlen (10) erzeugt wurden, umfassend die Schritte:
Definieren eines Analysekriteriums zur Analyse der erzeugten Modifikationen (12) im Inneren des Festkörpers (1);
Definieren eines Schwellenwerts hinsichtlich des Analysekriteriums, wobei ein Analysewert einerseits des Schwellenwerts eine Nachbearbeitungsregistrierung auslöst;
Analysieren des Wafers mit einer Analyseeinrichtung (4), wobei die Analyseeinrichtung (4) die Modifikationen (12) hinsichtlich des Analysekriteriums analysiert;
Ausgeben von Analysewerten zu den analysierten Modifikationen, wobei die Analysewerte oberhalb oder unterhalb des Schwellenwerts liegen;
Ausgeben von Ortsdaten zu den analysierten Modifikationen, wobei die Ortsdaten Informationen enthalten, in welchen/welchem Bereich/en des Festkörpers (1) der Analysewert oberhalb oder unterhalb des Schwellenwerts liegt;
Erzeugen von Steuerdaten zum Ansteuern einer Laserbehandlungseinrichtung (11) zum Nachbehandeln des Festkörpers (1), wobei die Steuerdaten zumindest die Ortsdaten von den zur Nachbearbeitung registrierten Festkörperanteilen umfassen.

2. Verfahren nach Anspruch 1,
**dadurch gekennzeichnet, dass**
die Analyseeinrichtung (4) eine Quelleneinrichtung (5) und eine Detektoreinrichtung (6) aufweist,
wobei die Quelleneinrichtung (5) Wellen aussendet und die Detektoreinrichtung (6) die durch den Festkörper (1) transmittierten Wellen und/oder die von dem Festkörper (1) reflektierten Wellen erfasst.

3. Verfahren nach Anspruch 2
**dadurch gekennzeichnet, dass**
die Quelleneinrichtung (5) weißes Licht emittiert und die Detektionseinrichtung (6) zum Erfassen von Licht unterschiedlicher Farbe ausgebildet ist, wobei die Detektionseinrichtung (6) ein Mittel zur Detektion von blauem Licht, ein Mittel zur Detektion von rotem Licht und ein Mittel zur Detektion von grünem Licht aufweist.

4. Verfahren nach einem der vorangegangenen Ansprüche,
**dadurch gekennzeichnet, dass**
der Schwellenwert vorgibt, wie viele Lichtanteile des mittels einer definierten Lichtquelle emittierten Lichts in einem definierten Festkörperanteil des Festkörpers (1) reflektiert werden müssen, damit für diesen definierten Festkörperanteil (1) kein Nachbearbeitungsbedarf bestimmt wird.

5. Verfahren nach einem der vorangegangenen Ansprüche,
**dadurch gekennzeichnet, dass**
der Schwellenwert angibt, welche Verteilung an schwarzen oder weißen Pixeln eines sich aus
einem Histogramm hinsichtlich blauer Pixel,
einem Histogramm hinsichtlich grüner Pixel und
einem Histogramm hinsichtlich roter Pixel
zusammen gesetzten schwarz/weiß Histogramm für einen definierten Bereich des Festkörpers (1) ergibt.

6. Verfahren nach einem der vorangegangenen Ansprüche,
**dadurch gekennzeichnet, dass**
der Festkörper (1) in eine Vielzahl gleichförmiger Bereiche unterteilt wird und für jeden der Bereiche eine Analyse hinsichtlich des Analysekriteriums durchgeführt wird, wobei Steuerdaten zum Nachbehandeln jedes Bereichs erzeugt werden, bezüglich dem die Auswertung der Analysewerte einen Nachbearbeitungsbedarf identifizieren.

7. Verfahren nach Anspruch 6,
**dadurch gekennzeichnet, dass**
die gleichförmigen Bereiche eine rechteckige Grundform ausbilden und bzgl. jedem Bereich, für den ein Nachbearbeitungsbedarf identifiziert wird, Steuerdaten zur vollständigen Nachbearbeitung dieses Bereichs erzeugt werden.

8. Verfahren nach einem der Ansprüche 6 oder 7,
**dadurch gekennzeichnet, dass**
zusätzlich ein übergeordnetes Schwellwertkriterium angewendet wird, wobei gemäß dem übergeordneten Schwellwertkriterium die Bereiche, für die ein Nachbearbeitungsbedarf identifiziert wurde, nicht nachbearbeitet werden, wenn die Gesamtfläche dieser Bereiche kleiner als ein vorgegebener Wert ist und/oder wenn ein Bereich oder mehrere Bereiche sich in einem vorgegebenen Abstand zu dem äußeren Rand des Festkörpers (1) oder zu einem Zentrum des Festkörpers (1) befindet oder befinden.

9. Verfahren zum Erzeugen von Modifikationen (12) in einem Festkörper (1), mindestens umfassend die Schritte:
Erzeugen von Modifikationen (12) mittels Laserstrahlen (10) einer Lasereinrichtung (11) in einem Festkörper (1) zum Vorgeben eines Rissverlaufs,
Durchführen eines Verfahrens nach einem der Ansprüche 6 bis 8 zum Erzeugung von Steuerdaten zur Nachbearbeitung des mittels der Laserstrahlen (10) modifizierten Festkörpers (1),
Erneutes Beaufschlagen der mittels der Steuerdaten identifizierten Festkörperanteile (C1) mit Laserstrahlen (10) der Lasereinrichtung (11).

10. Verfahren nach Anspruch 9,
**dadurch gekennzeichnet, dass**
das Verfahren zum Erzeugung von Steuerdaten zur Nachbearbeitung des mittels Laserstrahlen (10) modifizierten Festkörpers (1) zumindest zeitweise während der Erzeugung der Modifikationen (12) durchgeführt wird.

11. Verfahren nach Anspruch 9 oder 10,
**dadurch gekennzeichnet, dass**
mittels Algorithmen in Abhängigkeit von den erzeugten Modifikationen (12) und/oder von den noch zu erzeugenden Modifikationen (12) nach der Detektion von mindestens einem nachzubearbeitenden Bereich eine Überprüfung in Abhängigkeit eines weiteren Kriteriums, insbesondere Weg- und/oder Zeitkriteriums, erfolgt, wobei in Anhängigkeit von dem weiteren Kriterium weitere Modifikationen (12) erzeugt werden oder die Nachbearbeitung ausgeführt wird.

12. Verfahren nach einem der vorangegangenen Ansprüche,
**dadurch gekennzeichnet, dass**
die Modifikationen (12) lokale Risse im Kristallgitter und/oder in eine andere Phase überführte Materialanteile sind und/oder
die Modifikationen (12) mittels über eine äußere Oberfläche des Festkörpers (1), insbesondere an der eine Spannungserzeugungsschicht (16) angeordnet wird, eingeleitete Laserstrahlen (10) einer Lasereinrichtung (11) erzeugt werden.

13. Verfahren zum Abtrennen einer Festkörperschicht (4) von einem Festkörper (1), mindestens umfassend die Schritte:
Ausführen eines Verfahrens gemäß den Ansprüchen 9 bis 12,
Anordnen oder Erzeugen einer Spannungserzeugungsschicht (16) an dem Festkörper (1);
Thermisches Beaufschlagen der Spannungserzeugungsschicht (16) zum Erzeugen von Spannungen in dem Festkörper (1), wobei durch die Spannungserzeugung ein Riss ausgelöst wird, der sich entlang des vorgegebenen Rissverlaufs zum Abtrennen der Festkörperschicht (4) vom Festkörper (1) ausbreitet.

## Claims

1. Computer-implemented method for producing control data for postprocessing a solid body (1) that is modified by means of laser beams (10), wherein the solid body (1) has in its interior a multiplicity of modifications (12), wherein the modifications (12) were produced by means of the laser beams (10), comprising the steps of:
defining an analysis criterion for analysing the modifications (12) produced in the interior of the solid body (1);
defining a threshold value with respect to the analysis criterion, wherein an analysis value on one side of the threshold value triggers a postprocessing registration;
analysing the wafer with an analysis device (4), wherein the analysis device (4) analyses the modifications (12) with respect to the analysis criterion;
outputting analysis values relating to the analysed modifications, wherein the analysis values lie above or below the threshold value;
outputting spatial data relating to the analysed modifications, wherein the spatial data contain information regarding the region(s) of the solid body (1) in which the analysis value lies above or below the threshold value;
producing control data for controlling a laser treatment device (11) for the post-treatment of the solid body (1), wherein the control data comprise at least the spatial data of the solid-body portions registered for postprocessing.

2. Method according to Claim 1,
**characterized in that**
the analysis device (4) has a source device (5) and a detector device (6),
wherein the source device (5) emits waves and the detector device (6) captures the waves transmitted through the solid body (1) and/or the waves reflected by the solid body (1).

3. Method according to Claim 2,
**characterized in that**
the source device (5) emits white light and the detection device (6) is embodied for capturing light of different colours, wherein the detection device (6) has a means for detecting blue light, a means for detecting red light and a means for detecting green light.

4. Method according to one of the preceding claims,
**characterized in that**
the threshold value specifies how many light components of the light emitted by means of a defined light source must be reflected in a defined solid-body portion of the solid body (1) for no need for postprocessing to be determined for said defined solid-body portion (1).

5. Method according to one of the preceding claims,
**characterized in that**
the threshold value specifies what distribution of black or white pixels of a black/white histogram made up of a histogram with respect to blue pixels,
a histogram with respect to green pixels and
a histogram with respect to red pixels
is obtained for a defined region of the solid body (1).

6. Method according to one of the preceding claims,
**characterized in that**
the solid body (1) is divided into a multiplicity of uniform regions and an analysis with respect to the analysis criterion is performed for each of the regions, wherein control data are produced for the post-treatment of each region with respect to which the evaluation of the analysis values identifies a requirement for post-treatment.

7. Method according to Claim 6,
**characterized in that**
the uniform regions form a rectangular basic shape and, with respect to each region for which a requirement for postprocessing is identified, control data are produced for the completed postprocessing of said region.

8. Method according to one of Claims 6 or 7,
**characterized in that**
a superordinate threshold value criterion is additionally applied, wherein, according to the superordinate threshold value criterion, the regions for which a requirement for postprocessing has been identified are not postprocessed if the total area of said regions is less than a specified value and/or if one region or a plurality of regions is or are located at a specified distance from the outer periphery of the solid body (1) or from a centre of the solid body (1).

9. Method for producing modifications (12) in a solid body (1), comprising at least the steps of:
producing modifications (12) by means of laser beams (10) of a laser device (11) in a solid body (1) to specify a crack path,
carrying out a method according to one of Claims 6 to 8 for producing control data for postprocessing the solid body (1) modified by means of the laser beams (10),
exposing the solid-body portions (C1) identified by means of the control data again to laser beams (10) of the laser device (11).

10. Method according to Claim 9,
**characterized in that**
the method for producing control data for postprocessing the solid body (1) modified by means of laser beams (10) is carried out at least for a time during the production of the modifications (12).

11. Method according to Claim 9 or 10,
**characterized in that**,
after the at least one region that is to be postprocessed has been detected, a check is performed, by way of algorithms depending on the produced modifications (12) and/or on the modifications (12) that are still to be produced, on the basis of a further criterion, in particular a path and/or time criterion, wherein further modifications (12) are produced or the postprocessing is performed on the basis of the further criterion.

12. Method according to one of the preceding claims,
**characterized in that**
the modifications (12) are local cracks in the crystal lattice and/or material portions transitioned into a different phase, and/or
the modifications (12) are produced by means of laser beams (10) of a laser device (11) which are introduced via an outer surface of the solid body (1), in particular on which a stress-producing layer (16) is arranged.

13. Method for separating a solid-body layer (4) from a solid body (1), comprising at least the steps of:
carrying out a method according to Claims 9 to 12, arranging or producing a stress-producing layer (16) on the solid body (1);
applying heat to the stress-producing layer (16) for producing stresses in the solid body (1), wherein the stress production brings about a crack that propagates along the specified crack path for separating the solid-body layer (4) from the solid body (1).

## Revendications

1. Procédé mis en œuvre par ordinateur de production de données de commande, pour le post-traitement d'un semi-conducteur (1) modifié au moyen d'un rayonnement (10) laser, dans lequel le semi-conducteur (1) a à l'intérieur une pluralité de modifications (12), les modifications (12) ayant été produites au moyen du rayonnement (10) laser, comprenant les stades :
définition d'un critère d'analyse pour l'analyse des modifications (12) produites à l'intérieur du semi-conducteur (1) ;
définition d'une valeur de seuil du point de vue du critère d'analyse, une valeur d'analyse déclenchant de la part de la valeur de seuil un enregistrement de post-traitement ;
analyse de la tranche par un dispositif (4) d'analyse, le dispositif (4) d'analyse analysant les modifications (12) du point de vue du critère d'analyse ;
émission de valeurs d'analyse par rapport aux modifications analysées, les valeurs d'analyse étant au-dessus ou en dessous de la valeur de seuil;
émission de données d'emplacement par rapport aux modifications analysées, les données d'emplacement contenant des informations sur la partie/les parties du semi-conducteur (1) dans lesquelles la valeur d'analyse est au-dessus ou en dessous de la valeur de seuil ;
production de données de commande pour la commande d'un dispositif (11) de traitement laser, pour le post-traitement du semi-conducteur (1), les données de commande comprenant au moins des données d'emplacement des parties du semi-conducteur enregistrées pour le post-traitement.

2. Procédé suivant la revendication 1,
**caractérisé en ce que**
le dispositif (4) d'analyse a un dispositif (5) de source et un dispositif (6) de détecteur,
dans lequel le dispositif (5) de source émet des ondes et le dispositif (6) de détecteur détecte les ondes transmises par le semi-conducteur (1) et/ou les ondes réfléchies par le semi-conducteur (1).

3. Procédé suivant la revendication 2,
**caractérisé en ce que**
le dispositif (5) de source émet de la lumière blanche et le dispositif (6) de détection est constitué pour la détection de lumière de couleur différente, le dispositif (6) de détection ayant un moyen de détection de la lumière bleue, un moyen de détection de la lumière rouge et un moyen de détection de la lumière verte.

4. Procédé suivant l'une des revendications précédentes
**caractérisé en ce que**
la valeur de seuil prescrit combien de proportions de la lumière émise au moyen d'une source lumineuse définie doivent être réfléchies dans une partie définie du semi-conducteur (1), en déterminant ainsi que cette partie (1) définie du semi-conducteur n'a pas besoin d'un post-traitement.

5. Procédé suivant l'une des revendications précédente **caractérisé en ce que**
la valeur de seuil indique quelle répartition de pixels noirs ou blancs d'un histogramme noir/blanc, composé ensemble
d'un pixel bleu du point de vue de l'histogramme,
d'un pixel vert du point de vue de l'histogramme et
d'un pixel rouge du point de vue de l'histogramme
est obtenue pour une partie définie du semi-conducteur (1).

6. Procédé suivant l'une des revendications précédentes,
**caractérisé en ce que**
on subdivise le semi-conducteur en une pluralité de parties uniformes et on effectue pour chacune des parties une analyse du point de vue du critère d'analyse, dans lequel on produit des données de commande pour le post-traitement de chaque partie, pour lesquelles l'exploitation des valeurs d'analyse identifie un besoin de post-traitement.

7. Procédé suivant la revendication 6,
**caractérisé en ce que**
les parties uniformes constituent une forme de base rectangulaire et on produit pour chaque partie, pour laquelle on identifie un besoin de post-traitement, des données de commande pour le post-traitement complet de cette partie.

8. Procédé suivant l'une des revendications 6 ou 7, **caractérisé en ce que**
on applique en outre un critère de valeur de seuil, supérieur hiérarchiquement, dans lequel, suivant le critère de seuil, supérieur hiérarchiquement, on ne post-traite pas les parties, pour lesquelles on a identifié un besoin de post-traitement, si la surface totale de ces parties est plus petite qu'une valeur donnée à l'avance et/ou si une ou plusieurs parties se trouvent à une distance donnée à l'avance du bord extérieur du semi-conducteur (1) ou d'un centre du semi-conducteur (1).

9. Procédé de production de modifications (12) dans un semi-conducteur (1), comprenant au moins les stades :
on produit des modifications (12) au moyen d'un rayonnement (10) laser d'un dispositif (11) laser dans un semi-conducteur (1) pour la prescription d'un tracé de fissure,
on effectue un procédé suivant l'une des revendications 6 à 8 pour la production de données de commande pour le post-traitement du semi-conducteur (1) modifié au moyen du rayonnement (10) laser,
on soumet à nouveau les parties (C1) du semi-conducteur, identifiées au moyen des données de commande, au rayonnement (10) laser du dispositif (11) laser.

10. Procédé suivant la revendication 9
**caractérisé en ce que**
on effectue le procédé de production de données de commande pour le post-traitement du semi-conducteur (1) modifié au moyen du rayonnement (10) laser, au moins de temps à autre, pendant la production des modifications (12).

11. Procédé suivant la revendication 9 ou 10,
**caractérisé en ce que**
on effectue, au moyen d' algorithmes, en fonction des modifications (12) produites et/ou des modifications (12) à produire encore après la détection d'au moins une partie à retraiter, un contrôle en fonction d'un autre critère, notamment un critère de trajet/ou de temps, dans lequel on produit, en fonction de l'autre critère, d'autres modifications (12) ou on effectue le post-traitement.

12. Procédé suivant l'une des revendications précédentes,
**caractérisé en ce que**
les modifications (12) sont des fissures locales du réseau cristallin et/ou de parties du matériau transformées en une autre phase et/ou
on produit les modifications (12) au moyen d'un rayonnement (10) laser d'un dispositif (11) laser appliqué sur une surface extérieure du semi-conducteur (1), notamment sur celle où est disposée une couche (16) de production de tensions.

13. Procédé pour séparer une couche (4) de semi-conducteur d'un semi-conducteur (1) comprenant au moins les stades :
- on effectue un procédé suivant les revendications 9 à 12,
- on dispose ou on produit une couche (16) de production de tensions sur le semi-conducteur (1) ;
- on soumet à une contrainte thermique la couche (16) de production de tensions, pour produire des tensions dans le semi-conducteur (1), dans lequel on déclenche par la production de tensions une fissure, qui se propage le long du tracé donné à l'avance de la fissure, pour séparer la couche (4) de semi-conducteur du semi-conducteur (1).
